# EUROPEAN PATENT APPLICATION

(11) **EP 1 959 456 A1**
(43) Date of publication of application: **20.08.2008**
(21) Application number: 06833522.3
(22) Date of filing: 28.11.2006
(51) Int. Cl.: G11C 29/56, G01R 31/28, G11C 16/02

(54) **TEST DEVICE AND TEST METHOD**

(30) Priority: 08.12.2005 JP 2005355024
(71) Applicant: ADVANTEST CORPORATION, Nerima-ku, Tokyo 179-0071 (JP)
(72) Inventor: NIIJIMA, Hirokatsu, Tokyo 179-0071 (JP); SATO, Shinya, Tokyo 179-0071 (JP)
(74) Representative: Pfenning, Meinig & Partner GbR
(86) International application number: PCT/JP2006/323718
(87) International publication number: WO 2007/066541

(57) **Abstract**

An object of the invention is to effectively test a plurality of memories under test than ever before. The present invention provides a test apparatus that tests a plurality of memories under test. The test apparatus includes a data input-output section that is connected through a bus to data input-output terminals of the plurality of memories under test and gives and receives data to and from the data input-output terminals, a test data supplying section that parallel supplies test data to the plurality of memories under test via the data input-output section, a writing control section that parallel supplies a write enable signal to the plurality of memories under test in synchronization with the supply of the test data, a reading control section that sequentially supplies a read enable signal to each of the plurality of memories under test, a comparing section that compares the test data sequentially read from the respective memories under test with an expected value, and a detecting section that detects, on condition that one test data is not identical with the expected value, a writing fail for the memory under test that outputs this test data.

## Description

### TECHNICAL FIELD

The present invention relates to a test apparatus and a test method. More particularly, the present invention relates to a test apparatus that tests a plurality of memories under test in parallel and a test method therefor. The present application also relates to the following application, the contents of which are incorporated herein by reference if applicable.
1. A Japanese Patent Application No. 2005-355024 Filed on December 8, 2005.

### BACKGROUND ART

In order to raise efficiency of a test, a semiconductor memory testing apparatus is designed to be able to test a plurality of memories under test in parallel. Specifically, the semiconductor memory testing apparatus writes test data into each of the plurality of memories under test and causes each of the plurality of memories under test to output the written test data. Then, the semiconductor memory testing apparatus decides a quality of the respective memories under test by judging whether each of the output test data is identical with expectation data.

Here, when the memory under test is a flash memory, times required for testing the plurality of memories under test are not same due to errors for the reading and writing. For this reason, improvement of efficiency of the test is planned by providing various functions such that memories under test for which a fail of the test has been determined are controlled not to be tested by the following step and thus do not interfere with a test for the other memories under test.

In addition, since prior art documents are not now recognized, the description related to prior art documents is omitted.

### DISCLOSURE OF THE INVENTION

### PROBLEMS TO BE SOLVED BY THE INVENTION

The above-described semiconductor memory testing apparatus has a circuit (hereinafter, an input/output circuit) that controls input and output of test data into and to this memory under test in association with each of the plurality of memories under test. For this reason, the testing apparatus can read test data from each of the plurality of memories under test in parallel and decide a quality of each of the memories under test. When the memory under test is a flash memory, a reading procedure of test data is as below. First, the semiconductor memory testing apparatus issues a command for a reading start to the respective memories under test, and waits a predetermined time till the flash memory finishes setup for data output. Next, the semiconductor memory testing apparatus sequentially reads a plurality of test data from the plurality of memories under test in parallel.

Here, time necessary for reading test data is dominantly influenced on a waiting time from issuing the command for the reading start to reading initial data. For this reason, although test data are read from the plurality of memories under test in parallel, time necessary for reading shortened by parallel reading is very small. Furthermore, the same data may be simultaneously written into the plurality of memories under test during writing test data in many cases. In this manner, the plurality of input/output circuits may not be efficiently utilized in some cases in order to promote the efficiency of test.

On the contrary, if the number of the input/output circuits can be decreased by omitting a part of the input/output circuits that are not effectively utilized, a scale and an installation cost of the test apparatus can be saved. As a result, for example, it is considered that the number of the memories under test that can be tested in parallel and at the same time is increased, and thus a whole throughput for the test can be raised. In addition, although a part of the input/output circuits is omitted, it is desirable not to lose various types of functions for testing flash memories in parallel.

Therefore, it is an object of the present invention to provide a test apparatus and a test method that can solve the foregoing problems. The above and other objects can be achieved by combinations described in the independent claims. The dependent claims define further advantageous and exemplary combinations of the present invention.

### MEANS FOR SOLVING THE PROBLEMS

According to the first aspect of the present invention, there is provided a test apparatus that tests a plurality of memories under test. The test apparatus includes: a data input-output section that is connected through a bus to data input-output terminals of the plurality of memories under test and gives and receives data to and from the data input-output terminals; a test data supplying section that parallel supplies test data to the plurality of memories under test via the data input-output section; a writing control section that parallel supplies a write enable signal to the plurality of memories under test in synchronization with the supply of the test data in order to parallel write the test data into the plurality of memories under test; a reading control section that sequentially supplies a read enable signal to each of the plurality of memories under test in order to sequentially read the test data from each of the plurality of memories under test via the data input-output section; a comparing section that compares the test data sequentially read from the respective memories under test with an expected value; and a detecting section that detects, on condition that one test data is not identical with the expected value, a writing fail for the memory under test that outputs this test data.

Moreover, the memory under test may output a plurality of the test data for one memory block for one reading command, and the reading control section may parallel supply a reading command to the plurality of memories under test and sequentially supply the read enable signal to each of the memories under test in order to concurrently read the test data for one memory block from the plurality of memories under test.
Moreover, the test data supplying section and the writing control section may again write test data into the memory under test that generates the writing fail when the detecting section detects the writing fail, and the test apparatus may further include a test mask section that masks, when the detecting section detects the writing fail by a preset number of times for the same memory under test, a test for this memory under test and causes the other memory under test to be tested.

Moreover, the test apparatus may further include: a recording section that records, on condition that the detecting section detects the writing fail, bad information showing that a memory block having the writing fail is a bad block; and a test mask section that masks, when testing one memory block included in each of the plurality of memories under test, a test for the memory under test of which the memory block is a bad block and causes the other memory under test to be tested on the basis of the bad information recorded on the recording section.

According to the second aspect of the present invention, there is provided a test method for testing a plurality of memories under test. The test method includes: a test data supplying step of parallel supplying test data to the plurality of memories under test via a data input-output section that is connected through a bus to data input-output terminals of the plurality of memories under test and gives and receives data to and from the data input-output terminals; a writing control step of parallel supplying a write enable signal to the plurality of memories under test in synchronization with the supply of the test data in order to parallel write the test data into the plurality of memories under test; a reading control step of sequentially supplying a read enable signal to each of the plurality of memories under test in order to sequentially read the test data from each of the plurality of memories under test via the data input-output section; a comparing step of comparing the test data sequentially read from the respective memories under test with an expected value; and a detecting step of detecting, on condition that one test data is not identical with the expected value, a writing fail for the memory under test that outputs this test data.

The summary of the invention does not necessarily describe all necessary features of the present invention. The present invention may also be a sub-combination of the features described above.

### EFFECTS OF THE INVENTION

According to the present invention, it is possible to effectively test a plurality of memories under test than ever before.

### BRIEF DESCRIPTION OF THE DRAWINGS

FIG. 1 shows an entire configuration of a test apparatus 10.
FIG. 2 is a view showing a connecting circuit around memories under test 100-1 and 100-2.
FIG. 3 shows a functional configuration of a sense controller 140 and a fail memory 150.
FIG. 4 shows an operation timing of the test apparatus 10 according to an embodiment of the present invention during data writing.
FIG. 5 shows an operation timing of the test apparatus 10 according to an embodiment of the present invention during data reading.
FIG. 6 shows a functional configuration of the sense controller 140 and the fail memory 150 according to an alternative example of the present embodiment.

### REFERENCE NUMERALS

10 test apparatus
100 memory under test
110 timing generator
120 pattern generator
130 waveform shaper
132 data output section
135 timing output section
138 timing output section
140 sense controller
150 fail memory
152 bad block memory
154 address fail memory
160 data input-output section
170 driver
180 voltage supplying section
200 terminal-by-terminal measurement circuit
210 timing comparing section
220 logic comparing section
230 match detecting section
232 demultiplexer
234 demultiplexer
240 DUT-by-DUT measurement circuit
242 all-path detecting section
245 counter section
248 OR gate
250 multiplexer
256 multiplexer
258 multiplexer
260 test mask section
262 OR gate
272 demultiplexer
280 multiplexer
290 selecting section

### BEST MODE FOR CARRYING OUT THE INVENTION

The invention will now be described based on the preferred embodiments, which do not intend to limit the scope of the present invention, but exemplify the invention. All of the features and the combinations thereof described in the embodiment are not necessarily essential to the invention.

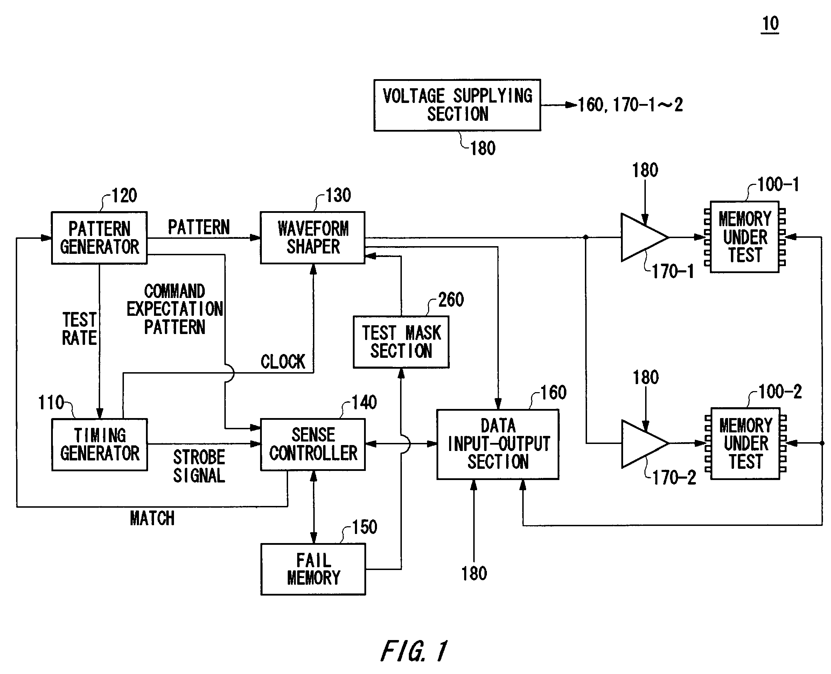

FIG. 1 shows an entire configuration of a test apparatus 10. The test apparatus 10 tests a memory function for memories under test 100-1 and 100-2. Here, each of the memories under test 100-1 and 100-2 is, for example, SoC (a system on chip) or the like to which a semiconductor memory or a memory function is added, and it is a flash memory as an example. Time necessary for reading data in the flash memory is a sum of a waiting time from issuing a command for a reading start to reading initial data and a time for really transferring data. Then, the waiting time becomes extremely larger than the time required for the data movement, and thus is more dominant than the time required for reading data. For this reason, although a circuit for inputting and outputting data is provided in each of the memories under test, a necessary time shortened by the circuit is very small. On the contrary, an object of the test apparatus 10 in the present embodiment is to simplify a configuration of the test apparatus 10 without reducing efficiency of a test by means of providing one input/output circuit (a data input-output section 160 in the present embodiment) for a plurality of memories under test in place of an input/output circuit every memory under test. Moreover, when writing test data, an object of the test apparatus 10 is to reduce a necessary time for the test by parallel writing the same test data from one input/output circuit into the plurality of memories under test.

The test apparatus 10 includes a timing generator 110, a pattern generator 120, a waveform shaper 130, a sense controller 140, a fail memory 150, a data input-output section 160, drivers 170-1 and 170-2, a voltage supplying section 180, and a test mask section 260. The timing generator 110 generates a cycle clock showing one cycle of a test and supplies the cycle clock to the waveform shaper 130 on the basis of a test rate signal output from the pattern generator 120. Moreover, the timing generator 110 outputs a strobe signal to the sense controller 140. This strobe signal is a signal controlling a timing at which output patterns output from the memories under test 100-1 and 100-2 are compared with expectation patterns. The pattern generator 120 generates test patterns supplied to the memories under test 100-1 and 100-2 and supplies the test patterns to the waveform shaper 130. Moreover, the pattern generator 120 outputs a command for writing test data into the memories under test 100-1 and 100-2 and a command for reading test data from the memories under test 100-1 and 100-2 to the sense controller 140.

The waveform shaper 130 shapes a waveform of the test pattern and outputs the shaped waveform to the data input-output section 160 and the drivers 170-1 and 170-2 on the basis of the supplied cycle clock and test pattern. The sense controller 140 is an example of a detecting section according to the present invention, and compares the test data acquired from the data input-output section 160 with the expectation pattern acquired from the pattern generator 120. Then, the sense controller 140 detects, on condition that one test data is not identical with an expected value, a writing fail for the memory under test that outputs this test data and writes the detection result into the fail memory 150. The fail memory 150 stores whether each of a plurality of blocks constituting the memories under test 100-1 and 100-2 is a bad block including data errors above the predetermined number.

The data input-output section 160 is connected to data input-output terminals of the memories under test 100-1 and 100-2, and gives and receives data to and from the data input-output terminals. Each of the drivers 170-1 and 170-2 is provided corresponding to each of the memories under test 100-1 and 100-2. Then, each of the drivers 170-1 and 170-2 outputs a write enable signal or a read enable signal to the corresponding memory under test in order to read and write data from and into the memories under test 100-1 and 100-2.

The voltage supplying section 180 outputs a reference voltage (VI) of an input signal for the memories under test 100-1 and 100-2. That is to say, for example, the input signal output from the waveform shaper 130 is amplified by a driver in the data input-output section 160 on the basis of the reference voltage (VI), and is input into the memories under test 100-1 and 100-2. Moreover, the voltage supplying section 180 outputs a reference voltage (VO) that is compared with a voltage of an output signal output from the memories under test 100-1 and 100-2. That is to say, for example, the outputs from the memories under test 100-1 and 100-2 are compared with the reference voltage (VO) by a comparator in the data input-output section 160, and are compared with the expectation pattern output from the pattern generator 120 by the sense controller 140. When it is detected that the memory under test has a bad block as a result of comparison, bad information showing that effect is recorded in the fail memory 150. Moreover, when the sense controller 140 detects that the same memory under test has writing fails by the preset number of times, the test mask section 260 masks a test for this memory under test and causes the other memory under test to be tested.

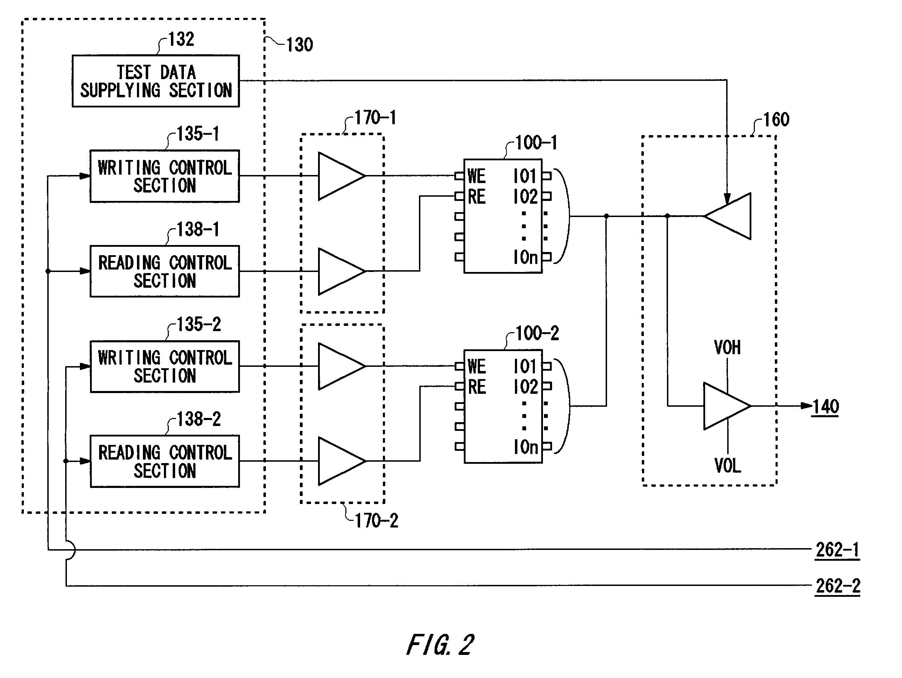

FIG. 2 is a view showing a connecting circuit around the memories under test 100-1 and 100-2. The waveform shaper 130 has a data output section 132, timing output sections 135-1 and 135-2, and timing output sections 138-1 and 138-2. The data output section 132 parallel supplies test data to the memories under test 100-1 and 100-2 via the data input-output section 160. That is to say, the data output section 132 supplies only a pair of test data to the memories under test 100-1 and 100-2, and the data input-output section 160 outputs the supplied test data to a signal line that is connected through a bus to both of the memories under test 100-1 and 100-2.

The timing output sections 135-1 and 135-2 function as a writing control section according to the present invention. That is to say, the timing output section 135-1 is provided corresponding to the memory under test 100-1, and supplies the write enable signal to the memory under test 100-1 in synchronization with the supply of test data in order to write the test data into the memory under test 100-1. Moreover, the timing output section 135-2 is provided corresponding to the memory under test 100-2, and supplies the write enable signal to the memory under test 100-2 in synchronization with the supply of test data in parallel with the timing output section 135-1. As a result, the timing output section 135-2 can write the test data into the memory under test 100-2 in parallel with the timing output section 135-1.

Moreover, when the memories under test 100-1 and 100-2 are, for example, a flash memory or the like, since the memory under test does not become a bad memory depending on the detection of one writing/reading fail, there is a problem what times of retry is required for correct reading. For this reason, the test apparatus 10 repeats writing until the number of retries reaches upper limit of the number of times even if the bad memory has been detected once. Specifically, when a writing fail has been detected by the sense controller 140 described below, the data output section 132 and the timing output sections 135-1 and 135-2 again write test data into the memory under test that causes the writing fail. More specifically, the data output section 132 and the timing output sections 135-1 and 135-2 output the next test data when a match signal is output by a match detecting section 230 described below, and continues to write the same test data on the basis of a predetermined test cycle unless the match signal is output.

The timing output sections 138-1 and 138-2 functions as a reading control section according to the present invention. That is to say, the timing output section 138-1 is provided corresponding to the memory under test 100-1, and sequentially supplies the read enable signal to the memory under test 100-1 in order to sequentially read test data from each of the memories under test 100-1 and 100-2 via the data input-output section 160. Moreover, the timing output section 138-2 is provided corresponding to the memory under test 100-2, and sequentially supplies the read enable signal to the memory under test 100-2 in order to sequentially read test data from each of the memories under test 100-1 and 100-2 via the data input-output section 160.

The data input-output section 160 is connected through a bus to the data input-output terminals of the memory under test 100-1 and the memory under test 100-2. Then, the data input-output section 160 outputs the test data supplied from the data output section 132 to these data input-output terminals. Moreover, the data input-output section 160 outputs the test data output from the memories under test 100-1 and 100-2 to the sense controller 140.

Each of the drivers 170-1 and 170-2 is provided corresponding to each of the memories under test 100-1 and 100-2. The driver 170-1 adjusts the write enable signal output from the timing output section 135-1 to a predetermined voltage level on the basis of the reference voltage (VI) of the input signal, and applies the adjusted signal to a terminal (WE) for inputting the write enable signal in the memory under test 100-1. Moreover, the driver 170-1 adjusts the read enable signal output from the timing output section 138-1 to a predetermined voltage level on the basis of the reference voltage (VI), and applies the adjusted signal to a terminal (RE) for inputting the read enable signal in the memory under test 100-1.

Similarly, the driver 170-2 adjusts the write enable signal output from the timing output section 135-2 to a predetermined voltage level on the basis of the reference voltage (VI), and applies the adjusted signal to the terminal (WE) of the memory under test 100-1. Moreover, the driver 170-2 adjusts the read enable signal output from the timing output section 138-2 to a predetermined voltage level on the basis of the reference voltage (VI), and applies the adjusted signal to the terminal (RE) of the memory under test 100-2.

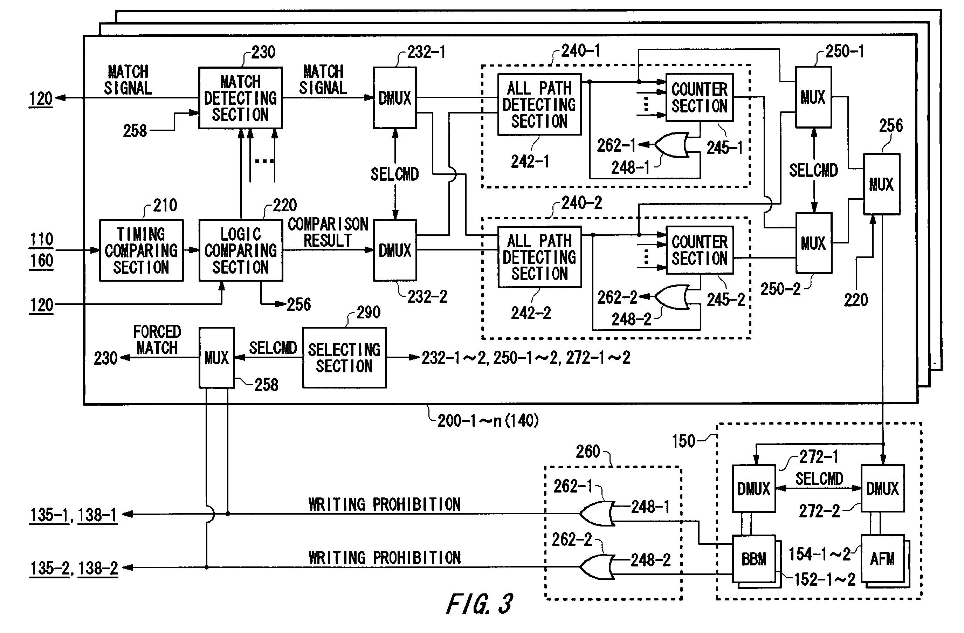

FIG. 3 shows a functional configuration of the sense controller 140 and the fail memory 150. The sense controller 140 has a measurement circuit for each of the data input-output terminals of the memories under test 100-1 and 100-2. Measurement circuits corresponding to the data input-output terminals IO1 to Ion are terminal-by-terminal measurement circuits 200-1 to 200-n. That is to say, the sense controller 140 has the terminal-by-terminal measurement circuits 200-1 to 200-n. In FIG. 3, it will be described about the terminal-by-terminal measurement circuit 200-1 corresponding to IO1 as a representative of these measurement circuits.

The terminal-by-terminal measurement circuit 200-1 has a timing comparing section 210, a logic comparing section 220, and a match detecting section 230, demultiplexers 232-1 and 232-2, DUT-by-DUT measurement circuits 240-1 and 240-2, multiplexers 250-1 and 250-2, a multiplexer 256, a multiplexer 258, and a selecting section 290. The timing comparing section 210 tests, for test data sequentially read from each of the memories under test 100-1 and 100-2, an output timing of a signal showing the test data. In this test, a strobe signal provided from the data input-output section 160 is used. The logic comparing section 220 compares test data sequentially read from each of the memories under test 100-1 and 100-2 with the expected value provided from the pattern generator 120.

The match detecting section 230 receives comparison results compared by the logic comparing section 220 for each of the test data output from the data input-output terminals IO1 to IOn. Then, when the all input comparison results show the matching between the test data and the expected values, the match detecting section 230 outputs a match signal indicative of that effect to the pattern generator 120 and the demultiplexer 232-1. Moreover, the match detecting section 230 outputs the match signal irrespective of the comparison result when receiving a forced match signal from the multiplexer 258.

The demultiplexer 232-1 outputs the match signal to the DUT-by-DUT measurement circuit 240-1 or the DUT-by-DUT measurement circuit 240-2 on the basis of a selection signal (SELCMD) showing whether any of the memories under test is tested. Moreover, the demultiplexer 232-2 outputs a comparison result between the test data and the expected value to the DUT-by-DUT measurement circuit 240-1 or the DUT-by-DUT measurement circuit 240-2 on the basis of the selection signal (SELCMD). Each of the DUT-by-DUT measurement circuits 240-1 and 240-2 is provided corresponding to each of the memories under test 100-1 and 100-2.

There is known a method for deciding a quality of each memory under test in each of the DUT-by-DUT measurement circuits 240-1 and 240-2. However, the DUT-by-DUT measurement circuits 240-1 and 240-2 generally take the following configuration when the memories under test 100-1 and 100-2 are a flash memory. Each of the DUT-by-DUT measurement circuits 240-1 and 240-2 has each of all-path detecting sections 242-1 and 242-2, each of counter sections 245-1 and 245-2, and each of OR gates 248-1 and 248-2. For a certain block to be tested within the memory under test 100-1, when all test data output via IO1 from the block are rightly read, the all-path detecting section 242-1 outputs a signal showing that effect to the multiplexer 250-1 and the OR gate 248-1. Similarly, for a certain block to be tested within the memory under test 100-2, when all test data output via IO1 from the block are rightly read, the all-path detecting section 242-2 outputs a signal showing that effect to the multiplexer 250-1 and the OR gate 248-2.

The OR gate 248-1 receives a signal showing that the number of fail detections reaches upper limit and a signal showing that all test data output via IO1 from a block to be tested are correctly read, and outputs a logical sum of these signals to an OR gate 262-1. The OR gate 248-2 receives a signal showing that the number of fail detections reaches upper limit and a signal showing that all test data output via IO1 from a block to be tested are correctly read, and outputs a logical sum of these signals to an OR gate 262-2.

The counter section 245-1 counts the number of retry reading until test data are identical with expected values in all data input-output terminals of the memory under test 100-1. Moreover, when the number of times reaches a predetermined upper limit, the counter section 245-1 outputs the number of times to the multiplexer 250-2 and outputs a control signal showing that the number of times reaches upper limit to the OR gate 248-1. Similarly, the counter section 245-2 counts the number of retry reading until test data are identical with expected values in all data input-output terminals of the memory under test 100-2. Moreover, when the number of times reaches the predetermined upper limit, the counter section 245-2 outputs the number of times to the multiplexer 250-2 and outputs a control signal showing that the number of times reaches upper limit to the OR gate 248-2.

The multiplexer 250-1 selects an output signal from the all-path detecting section 242-1 or the all-path detecting section 242-2 on the basis of the selection signal (SELCMD) and outputs the selected signal to the multiplexer 256. The multiplexer 250-2 selects an output signal from the counter section 245-1 or the counter section 245-2 on the basis of the selection signal (SELCMD) and outputs the selected signal to the multiplexer 256. The multiplexer 256 serializes a comparison result by the logic comparing section 220, an output signal from the multiplexer 250-1, and an output signal from the multiplexer 250-2, and sends the result to the fail memory 150.

The multiplexer 258 selects a writing prohibition signal corresponding to the memory under test 100-1 or a writing prohibition signal corresponding to the memory under test 100-2 on the basis of the selection signal (SELCMD), and outputs the selected signal to the match detecting section 230 as a forced match signal. The selecting section 290 outputs the selection signal (SELCMD) in synchronization with the read enable signal output by each of the timing output sections 138-1 and 138-2. This selection signal is output to the demultiplexers 232-1 and 232-2, the multiplexers 250-1 and 250-2, the multiplexer 258, and the demultiplexers 272-1 and 272-2.

Moreover, the fail memory 150 has bad block memories 152-1 and 152-2, address fail memories 154-1 and 154-2, and demultiplexers 272-1 and 272-2. The bad block memories 152-1 and 152-2 are an example of a recording section according to the present invention, and records, on condition that the sense controller 140 detects a writing fail, bad information showing that the memory block having the writing fail is a bad block. More specifically, the bad block memory 152-1 records bad information for the memory under test 100-1, and the bad block memory 152-2 records bad information for the memory under test 100-2. Then, the demultiplexer 272-1 selects the bad block memory 152-1 or the bad block memory 152-2 by the selection signal (SELCMD), and records the bad information provided from the sense controller 140 for the selected bad block memory. Alternatively, an area of a part of a memory consisting of one address space functions as the bad block memory 152-1 and another area functions as the bad block memory 152-2, and thus the memory may be accessed by an address according to the SELCMD.

The address fail memories 154-1 and 154-2 store the effect that data output from the memories under test 100-1 and 100-2 and the expected value are not identical in an address corresponding to this data. More specifically, the address fail memory 154-1 stores, for data output from the memory under test 100-1, the effect that the data and the expected value are not identical, and the address fail memory 154-2 stores, for data output from the memory under test 100-2, the effect that the data and the expected value are not identical. Then, the demultiplexer 272-2 causes an address fail memory selected by the selection signal (SELCMD) to store data indicative of bad provided from the sense controller 140. Alternatively, an area of a part of a memory consisting of one address space may function as the address fail memory 154-1, and another area may function as the address fail memory 154-2.

When testing one memory block included in each of the memories under test 100-1 and 100-2, the test mask section 260 masks a test for the memory under test of which the memory block is a bad block and causes the other memory under test to be tested on the basis of the bad information recorded on the bad block memory 152. Specifically, the test mask section 260 has the OR gates 262-1 and 262-2. In regard to a block to be tested, the OR gate 262-1 receives a logical sum of a signal showing that the number of fail detections reaches upper limit and a signal showing that all test data output via IO1 from the block are correctly read, from the OR gate 248-1. Moreover, the OR gate 262-1 receives the bad information recorded on the bad block memory 152-1. When either of the input signals is truth, the OR gate 262-1 outputs a writing prohibition signal in order to invalidate the following test for the memory under test 100-1.

Similarly, the OR gate 262-2 receives a logical sum of a signal showing that the number of fail detections reaches upper limit and a signal showing that all test data output via IO1 from the block are correctly read, from the OR gate 248-2. Moreover, the OR gate 262-2 receives the bad information recorded on the bad block memory 152-2. When either of the input signals is truth, the OR gate 262-2 outputs a writing prohibition signal in order to invalidate the following test for the memory under test 100-2. The multiplexer 258 receives this writing prohibition signal, and outputs a forced match signal to the match detecting section 230. As a result, the subsequent tests are controlled like that test data are always identical with expected values. According to this, it is possible to mask a test for a memory under test for which fail detection has been already decided in order to test another memory under test, and further to prevent redundantly writing data into a block for which normal detection has been already decided in order to raise test efficiency.

The selecting section 290 outputs the selection signal (SELCMD) for selecting the memory under test 100-1 or the memory under test 100-2 as an object to be tested. This selection signal is output at a timing at which test data are read from the memories under test 100-1 and 100-2 in synchronization with the read enable signal for reading the test data from the memories under test 100-1 and 100-2.

In addition, according to a functional configuration shown in FIG. 3, it is necessary to provide the DUT-by-DUT measurement circuits 240-1 and 240-2 in association with each of the memories under test 100-1 and 100-2, and thus it is considered that a necessary space of a circuit increases. However, according to technical innovation of recent ASIC, since a packaging density of a circuit becomes extremely high, the increase of a circuit scale is very small depending on the increase of a circuit packaging density. On the other hand, it is effective to decrease input-output terminals of the test apparatus 10 in order to reduce a cost for introduction and management of the test apparatus 10, and this can be realized by providing only one data input-output section 160 for the plurality of memories under test.

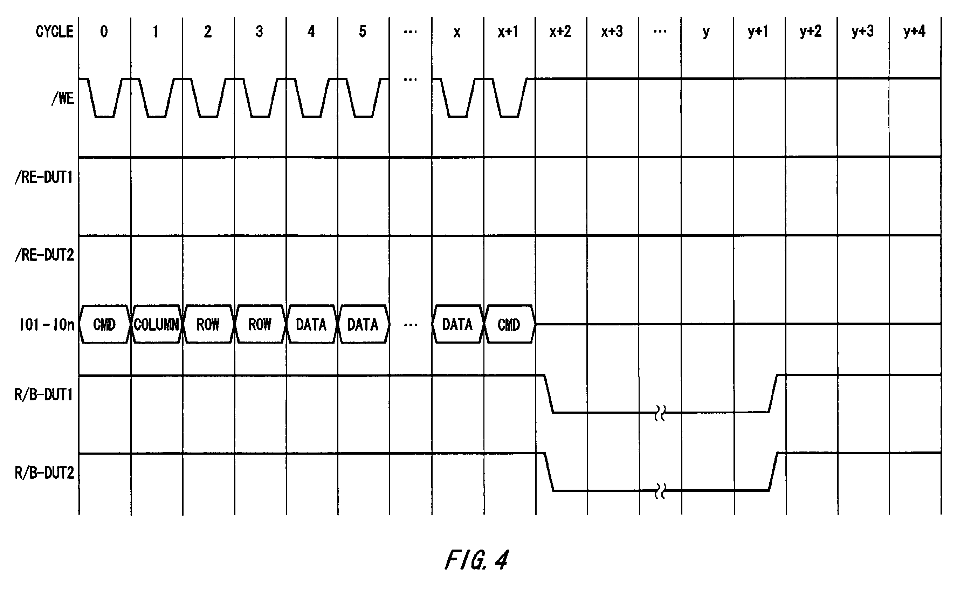

FIG. 4 shows an operation timing of the test apparatus 10 according to an embodiment of the present invention during data writing. The timing output sections 135-1 and 135-2 parallel supply the write enable signal to each of the memories under test 100-1 and 100-2 in each cycle of the 0^{th} cycle to the (x+1)^{th} cycle. In synchronization with this, the data output section 132 parallel supplies test data to the memories under test 100-1 and 100-2 via the data input-output section 160.

A format of the supplied test data is determines in accordance with a standard of the memories under test 100-1 and 100-2. Specifically, in an example of FIG. 4, the data output section 132 firstly outputs a command (CMD) indicating writing of data (0^{th} cycle). Subsequently, the data output section 132 sequentially outputs data specifying a column and a row that become an object to be written (1^{st} to 3^{rd} cycles). Further, the data output section 132 sequentially outputs test data as object data to be written (4^{th} to x^{th} cycles). Finally, the data output section 132 outputs a command (CMD) showing the effect that an output of object data to be written has been finished ((x+1)^{th} cycle).

When receiving this write processing, the memory under test 100-1 sets a signal R/B showing during write processing to "0" and the memory under test 100-2 sets a signal R/B showing during write processing to "0". At the time point at which the signals R/B become "1" in both the memories under test, writing of test data into the memories under test 100-1 and 100-2 by the test apparatus 10 is completed.
As above, like an example of the present drawing, the test apparatus 10 writes test data into each of the memories under test 100-1 and 100-2. In this write processing, the test apparatus 10 can parallel write the same test data into each of the memories under test 100-1 and 100-2 by means of the one data input-output section 160.

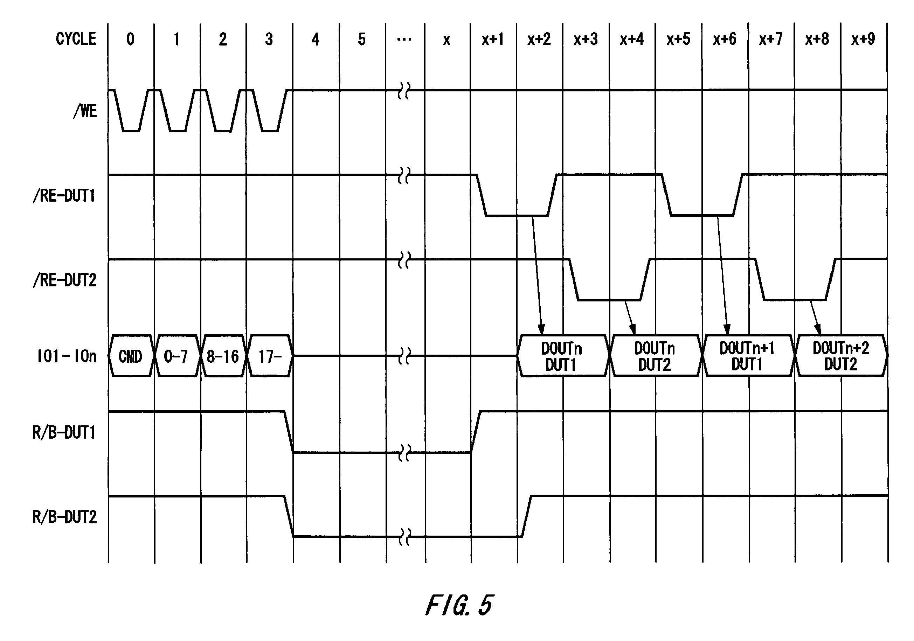

FIG. 5 shows an operation timing of the test apparatus 10 according to an embodiment of the present invention during data reading. In each cycle of the 0^{th} cycle to the 3^{rd} cycle, the timing output section 135-1 and 135-2 output the write enable signal in order to issue a command for data reading to the memories under test 100-1 and 100-2. In synchronization with this, the data output section 132 outputs a command (CMD) indicating reading of data by one memory block from the memory under test (0^{th} cycle). Subsequently, the data output section 132 outputs an address becoming an object to be read (1^{st} cycle to 3^{rd} cycle). According to this command, it is possible to output test data by one memory block, which are located at the specified address.

When an address of an object to be read is specified, the memories under test 100-1 and 100-2 start a process in order to allow data on the address to be output. During this process, the R/B signal becomes "0". In an example of FIG. 5, since reading instruction is performed on the memories under test 100-1 and 100-2 in parallel, R/B of the memory under test 100-1 and R/B of the memory under test 100-2 together become "0". Then, a process of the memory under test 100-1 is completed in the (x+1)^{th} cycle, and a process of the memory under test 100-2 is completed in the (x+2)^{th} cycle.

Next, the data output section 132 parallel supplies a reading command to the memories under test 100-1 and 100-2. In an example of FIG. 5, the data output section 132 firstly outputs a command reading the n^{th} column data to the memory under test 100-1, and next outputs the command reading the n^{th} column data to the memory under test 100-2. Subsequently, the data output section 132 outputs a command reading the (n+1)^{th} column data to the memory under test 100-1, and next outputs the command reading the (n+1)^{th} column data to the memory under test 100-2.

In synchronization with this, the timing output sections 138-1 and 138-2 sequentially supply the read enable signal to each of the memories under test 100-1 and 100-2. For example, the timing output section 138-1 firstly supplies the read enable signal to the memory under test 100-1 (x^{th}+1 and x^{th}+2 cycles). Next, the timing output section 138-2 supplies the read enable signal to the memory under test 100-2 (x^{th}+3 and x^{th}+4 cycles). Next, the timing output section 138-1 supplies the read enable signal to the memory under test 100-1 (x^{th}+5 and x^{th}+6 cycles). Next, the timing output section 138-2 supplies the read enable signal to the memory under test 100-2 (x^{th}+7 and x^{th}+8 cycles). In this manner, the timing output sections 138-1 and 138-2 can sequentially and alternately output the read enable signal to the memories under test 100-1 and 100-2 in order to concurrently read test data by one memory block from each of the memories under test 100-1 and 100-2.

In addition, when alternately reading test data from each of the memories under test 100-1 and 100-2 in this manner, it is considered to need a time of two times in comparison with when reading test data from each of the memories under test 100-1 and 100-2 in parallel. However, as already described, a time required for reading test data is dominantly influenced on a necessary time from issuing a reading command to reading initial test data. Furthermore, reading of test data can be performed independently of a test-period cycle. For example, reading of test data may be performed in 1/2 cycles of a conventional reading cycle. As a result, although test data are alternately read from the memories under test 100-1 and 100-2, it is possible to complete a process with processing time and power consumption equal to those of till now.

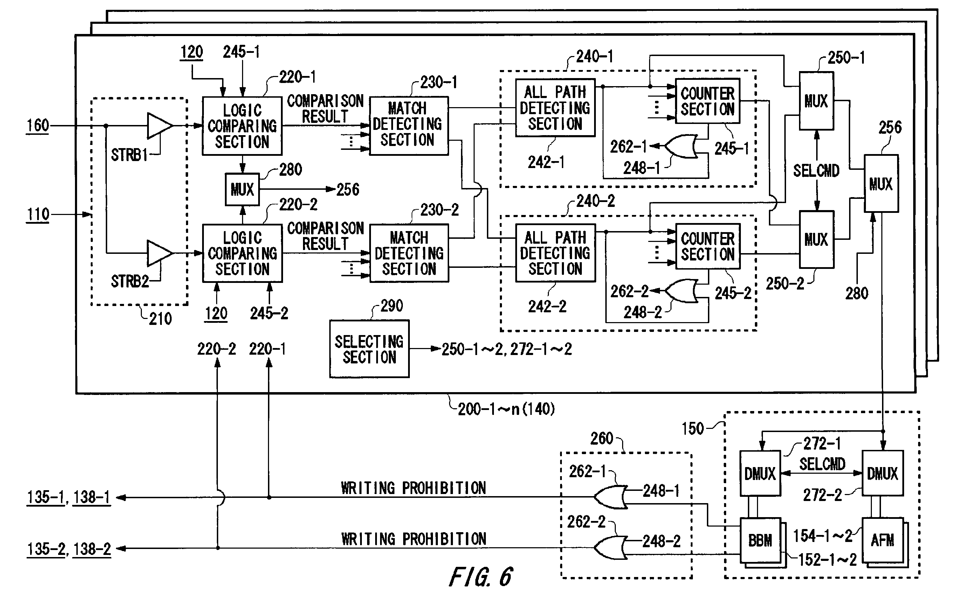

FIG. 6 shows a functional configuration of the sense controller 140 and the fail memory 150 according to an alternative example of the present embodiment. An object of the present alternative example is to perform a timing test and a logic test on each of the memories under test 100-1 and 100-2 in parallel. The sense controller 140 in the present alternative example has terminal-by-terminal measurement circuits 200-1 to 200-n similarly to the sense controller 140 shown in FIG. 3. The terminal-by-terminal measurement circuit 200-1 in the present alternative example has logic comparing sections 220-1 and 220-2 in place of the logic comparing section 220 and has match detecting sections 230-1 and 230-2 in place of the match detecting section 230, unlike with the terminal-by-terminal measurement circuit 200-1 shown in FIG. 3. Moreover, the terminal-by-terminal measurement circuit 200-1 may not have the demultiplexers 232-1 and 232-2, and alternatively has the multiplexer 280.

Moreover, the timing comparing section 210 in the present alternative example receives a strobe signal corresponding to each of the memories under test 100-1 and 100-2 from the test apparatus 10. Then, the timing comparing section 210 tests an output timing of a signal showing test data on the basis of the input strobe signal independently of each of the memories under test 100-1 and 100-2. The logic comparing section 220-1 is provided corresponding to the memory under test 100-1, and sequentially compares the test data sequentially read from the memory under test 100-1 with the expected values and sends comparison results to the match detecting section 230-1. Moreover, although the test data and the expected value are not identical with each other when the logic comparing section 220-1 receives the writing prohibition signal from the OR gate 262-1, the logic comparing section 220-1 outputs a comparison result showing that they are identical.

Similarly, the logic comparing section 220-2 is provided corresponding to the memory under test 100-2, and sequentially compares the test data sequentially read from the memory under test 100-2 with the expected values and sends comparison results to the match detecting section 230-2. Moreover, although the test data and the expected value are not identical with each other when the logic comparing section 220-2 receives the writing prohibition signal from the OR gate 262-2, the logic comparing section 220-2 outputs a comparison result showing that they are identical.

The match detecting section 230-1 is provided corresponding to the memory under test 100-1, and receives comparison results obtained by comparing the respective test data output from the data input-output terminals IO1 to IOn of the memory under test 100-1 and the expected values by means of the logic comparing section 220-1. Then, when the input all comparison results show that the test data and the expected values are identical, the match detecting section 230-1 outputs a match signal showing that effect to the DUT-by-DUT measurement circuit 240-1 and the DUT-by-DUT measurement circuit 240-2.

Similarly, the match detecting section 230-2 is provided corresponding to the memory under test 100-2, and receives comparison results obtained by comparing the respective test data output from the data input-output terminals IO1 to IOn of the memory under test 100-2 and the expected values by means of the logic comparing section 220-2. Then, when the input all comparison results show that the test data and the expected values are identical, the match detecting section 230-2 outputs a match signal showing that effect to the DUT-by-DUT measurement circuit 240-1 and the DUT-by-DUT measurement circuit 240-2.

The multiplexer 280 serializes the comparison results by the logic comparing section 220-1 and the logic comparing section 220-2, and sends the serialized result to the multiplexer 256. The multiplexer 256 serializes the comparison result received from the multiplexer 280 and the comparison results received from the multiplexers 250-1 and 250-2, and outputs the result to the fail memory 150.
In this manner, according to the present alternative example, it is also possible to reduce a necessary space or the like of a circuit of the test apparatus 10 because it is not necessary that each memory under test has an input/output circuit.

Although the present invention has been described by way of an exemplary embodiment, it should be understood that those skilled in the art might make many changes and substitutions without departing from the spirit and the scope of the present invention. It is obvious from the definition of the appended claims that embodiments with such modifications also belong to the scope of the present invention.

## Claims

1. A test apparatus that tests a plurality of memories under test, comprising:
a data input-output section that is connected through a bus to data input-output terminals of the plurality of memories under test and gives and receives data to and from the data input-output terminals;
a test data supplying section that parallel supplies test data to the plurality of memories under test via the data input-output section;
a writing control section that parallel supplies a write enable signal to the plurality of memories under test in synchronization with the supply of the test data in order to parallel write the test data into the plurality of memories under test;
a reading control section that sequentially supplies a read enable signal to each of the plurality of memories under test in order to sequentially read the test data from each of the plurality of memories under test via the data input-output section;
a comparing section that compares the test data sequentially read from the respective memories under test with an expected value; and
a detecting section that detects, on condition that one test data is not identical with the expected value, a writing fail for the memory under test that outputs this test data.

2. The test apparatus as claimed in claim 1, wherein
the memory under test outputs a plurality of the test data for one memory block for one reading command, and
the reading control section parallel supplies a reading command to the plurality of memories under test and sequentially supplies the read enable signal to each of the memories under test in order to concurrently read the test data for one memory block from the plurality of memories under test.

3. The test apparatus as claimed in claim 1, wherein
the test data supplying section and the writing control section again write test data into the memory under test that generates the writing fail when the detecting section detects the writing fail, and
the test apparatus further comprises a test mask section that masks, when the detecting section detects the writing fail by a preset number of times for the same memory under test, a test for this memory under test and causes the other memory under test to be tested.

4. The test apparatus as claimed in claim 1, further comprising:
a recording section that records, on condition that the detecting section detects the writing fail, bad information showing that a memory block having the writing fail is a bad block; and
a test mask section that masks, when testing one memory block included in each of the plurality of memories under test, a test for the memory under test of which the memory block is a bad block and causes the other memory under test to be tested on the basis of the bad information recorded on the recording section.

5. A test method for testing a plurality of memories under test, comprising:
a test data supplying step of parallel supplying test data to the plurality of memories under test via a data input-output section that is connected through a bus to data input-output terminals of the plurality of memories under test and gives and receives data to and from the data input-output terminals;
a writing control step of parallel supplying a write enable signal to the plurality of memories under test in synchronization with the supply of the test data in order to parallel write the test data into the plurality of memories under test;
a reading control step of sequentially supplying a read enable signal to each of the plurality of memories under test in order to sequentially read the test data from each of the plurality of memories under test via the data input-output section;
a comparing step of comparing the test data sequentially read from the respective memories under test with an expected value; and
a detecting step of detecting, on condition that one test data is not identical with the expected value, a writing fail for the memory under test that outputs this test data.
